# EUROPÄISCHE PATENTANMELDUNG

(11) **EP 1 314 975 A1**
(43) Veröffentlichungstag der Anmeldung: **28.05.2003**
(21) Anmeldenummer: 02102544.0
(22) Anmeldetag: 06.11.2002
(51) Int. Cl.: G01N 21/95, H04N 1/10, G02B 26/10

(54) **Verfahren und Vorrichtung zur Defektanalyse von Wafern**

(30) Priorität: 22.11.2001 DE 10157244
(71) Anmelder: Leica Microsystems Semiconductor GmbH, 35578 Wetzlar (DE)
(72) Erfinder: MAINBERGER, Robert, 35619, Braunfels (DE)
(74) Vertreter: Reichert, Werner F., Dr.

(57) **Zusammenfassung**

Ein einfaches, schnelles und kostengünstiges Verfahren zur Defektanalyse von Wafern (5) und ein Defektanalysesystem sind offenbart. Das Defektanalysesystem mit einer optischen Abtastvorrichtung (11) und einer Bildverarbeitungseinheit (15) ist dadurch gekennzeichnet, dass die optische Abtastvorrichtung (11) ein Flachbettscanner ist. In einer bevorzugten Ausgestaltung ist die Wellenlänge des Beleuchtungslichts auswählbar. Das optische Abtasten erfolgt mehrmals sequentiell hintereinander jeweils mit Beleuchtungslicht unterschiedlicher Wellenlänge.

## Beschreibung

Weiterhin betrifft die Erfindung Defektanalysesystem für Wafer mit einer optischen Abtastvorrichtung und einer Bildverarbeitungseinheit.

Vorrichtungen zur Waferinspektion sind weithin bekannt.

Die deutsche Offenlegungsschrift DE 34 22 143 A1 offenbart ein Gerät zur Wafer-Inspektion mit einem Laser-Abtast-Mikroskop, dessen Objektiv das Abtastlichtbündel mit einer geringen Schärfentiefe auf den Untersuchungsbereich fokussiert, wobei der zur Messung der Intensität des aus dem Untersuchungsbereich zurückgeworfenen Lichtes benutzte Nachweisstrahlung durch einen Teil des Abtaststrahlenganges des Laser-Abtastmikroskopes gebildet ist. In konfokaler Anordnung die Untersuchungsebene durch die Brennebene des Mikroskop-Objektivs bestimmt. Das Abtastmikroskop beinhaltet einen aktiven Abtastspiegel mit elektronisch steuerbarer Brechkraft, durch dessen Ansteuerung die Fokussierungs- bzw. Untersuchungsebene, bezogen auf eine Wafer-feste Bezugsebene im Sinne einer Anhebung und/oder Absenkung veränderbar ist. Die Abtastung des Wafers erfolgt punktweise indem das Abtastlichtbündel zeilenweise über den Wafer geführt wird. Je nach der Brennweite des Mikroskopobjektivs variiert die Größe des Bildfeldes zwischen 100 µm und mehreren mm; entsprechend variiert die Bildpunktgröße zwischen 0,05 µm und einigen µm.

Die US-Patentschrift 5,917,588 offenbart ein Verfahren zur Inspektion von Oberflächen einer Probe, insbesondere zur Inspektion von Wafern, und ein Inspektionssystem. Das Inspektionssystem beinhaltet ein aufwendiges Dunkelfeld-Beleuchtungssystem und/oder ein aufwendiges Weitfeld-Beleuchtungssystem mit mehreren stationären Einzellichtquellen. Das System ist in der Lage Defekte, die größer als 25 µm sind, zu erkennen.

Flachbettscanner sind bei PC-Nutzern zum Abscannen von Papiervorlagen bekannt.

Ein Nachteil des aus der deutschen Offenlegungsschrift DE 34 22 143 A1 bekannten Systems ist die Langsamkeit und das räumlich sehr begrenzte Bildfeld. Das Abscannen eines Wafers mit einem üblichen Durchmesser von 300 mm würde Stunden dauern, wobei die dabei erzielte Auflösung für eine Grobdefektanalyse unnötig gut wäre.

Das erwähnte, aus der US-Patentschrift 5,917,588 bekannte Inspektionssystem ist aufwendig und teuer. Darüber hinaus benötigt das Inspektionssystem zum Untersuchen eines Wafers von nur 200 mm Durchmesser Zeiten im Minutenbereich.

Der Erfindung liegt daher die Aufgabe zugrunde, ein einfaches, schnelles und kostengünstiges Verfahren zur Defektanalyse von Wafern anzugeben.

Obige Aufgabe wird durch ein Verfahren zur Defektanalyse von Wafern, das durch folgende Schritte gekennzeichnet ist, gelöst:
- Erzeugen von Bilddaten durch optisches Abtasten des Wafers mit einem Flachbettscanner,
- Übermitteln der Bilddaten an eine Bildverarbeitungseinheit und
- Auswerten der erzeugten Bilddaten in der Bildverarbeitungseinheit.

Es ist weiterhin Aufgabe der Erfindung, ein einfaches, schnelles und effizientes und darüber hinaus kostengünstiges Defektanalysesystem für Wafer anzugeben.

Diese Aufgabe wird durch ein Defektanalysesystem gelöst, das dadurch gekennzeichnet ist, dass die optische Abtastvorrichtung ein Flachbettscanner ist.

Die Erfindung hat den Vorteil, dass selbst große Wafer mit 300 mm Durchmesser in Bruchteilen einer Minute mit hinreichend großer Auflösung auf Defekte untersucht werden können.

Vorteilhafter Weise ist der Flachbettscanner ein kommerziell im Computerzubehörhandel erhältlicher Flachbettscanner für Büroanwendungen. Diese Art von Flachbettscannern ist besonders preisgünstig und zuverlässig.

In einer bevorzugen Ausgestaltung umfasst das optische Abtasten des Wafers das Beleuchten des Wafers mit Beleuchtungslicht und das Detektieren von vom Wafer ausgehenden Detektionslicht. Zur Beleuchtung dienen vorzugsweise farbige oder weiße Leuchtdioden. Zur Beleuchtung können auch Kaltlichtquellen dienen.

In einer anderen bevorzugten Ausgestaltung ist die Wellenlänge des Beleuchtungslichts auswählbar. Das erfindungsgemäße Verfahren beinhaltet vorzugsweise den weiteren Schritt des Auswählens der Wellenlänge des Beleuchtungslichtes. In einer Ausführungsvariante erfolgt das optische Abtasten mehrmals sequentiell hintereinander jeweils mit Beleuchtungslicht unterschiedlicher Wellenlänge.

Die Bildverarbeitungseinheit umfasst vorzugsweise einen PC mit Software zur Bildanalyse und Bildbewertung. Der Flachbettscanner kann als Zeilenscanner ausgeführt sein. Der Flachbettscanner des Defektanalysesystems umfasst mindestens eine Beleuchtungseinheit, die Beleuchtungslicht emittiert.

Vorzugsweise ist ein Handlingsystem vorgesehen, das die zu untersuchenden Wafer zu dem Flachbettscanner transportiert. Das Abscannen kann vorzugsweise von oben bei kopfstehendem Flachbettscanner oder von unten, wobei die Oberseite des Wafers nach unten gedreht ist, erfolgen. In dem Defektanalysesystem kann der Flachbettscanner auch lotrecht angeordnet sein.

In der Zeichnung ist der Erfindungsgegenstand schematisch dargestellt und wird anhand der Figuren nachfolgend beschrieben, wobei gleich wirkende Elemente mit denselben Bezugszeichen versehen sind. Dabei zeigen:
- Fig. 1: ein Defektanalysesystem und
- Fig. 2: eine weiteres Defektanalysesystem.

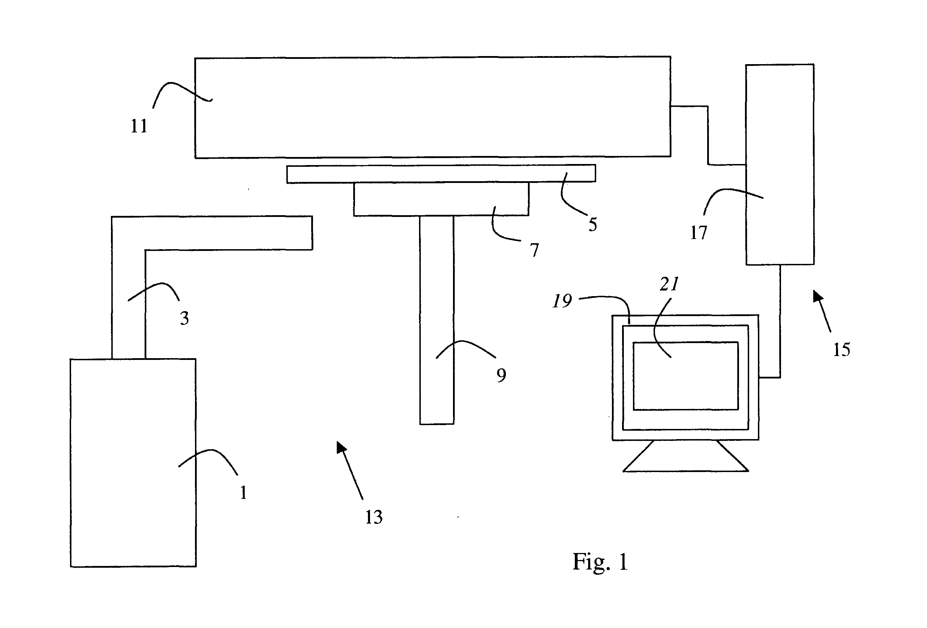

Fig. 1 zeigt ein Defektanalysesystem, das einen Roboter 1 mit einem steuerbaren Roboterarm 3 umfasst. Der Roboter dient dazu, den Wafer 5 aus den nicht gezeigten Kassetten zu entnehmen und zu dem Waferchuck 7 zu transportieren. Der Waferchuck verfügt über eine Unterdruckansaugung. Der Waferchuck 7 ist auf einem motorisierten, höhenverstellbaren Tisch 9 angeordnet. Der Tisch 9 transportiert den Wafer 5 in einer Linearbewegung zum kopfstehendem Flachbettscanner 11, wobei dieser nicht berührt wird, um den Wafer nicht zu beschädigen. Der Roboter 1, der Roboterarm 3, der Tisch und der Chuck bilden ein Handlingsystem 13. Der Flachbettscanner 11 ist als Zeilenscanner ausgeführt und tastet den Wafer 5 ab. Die erzeugten Bilddaten werden an eine Bildverarbeitungseinheit 15 weitergegeben, die aus einem PC 17 mit Software zur Bildanalyse und Bildbewertung besteht. Der PC 17 steuert darüber hinaus das Handlingsystem 13. Das Abbild 21 des Wafers 5 wird auf dem Display 19 angezeigt, wobei die Defekten Stellen des Wafers 5 markiert sind. Der Roboter 1 könnte den Wafer 5 während des Abrasterns anstelle des Tisches 9 halten. Ein einen Tisch 9 umfassendes Handlingsystem hat jedoch den Vorteil, der Roboter 1 während des Abrasterns weitere Wafer zu weiteren Flachbettscannern transportieren kann.

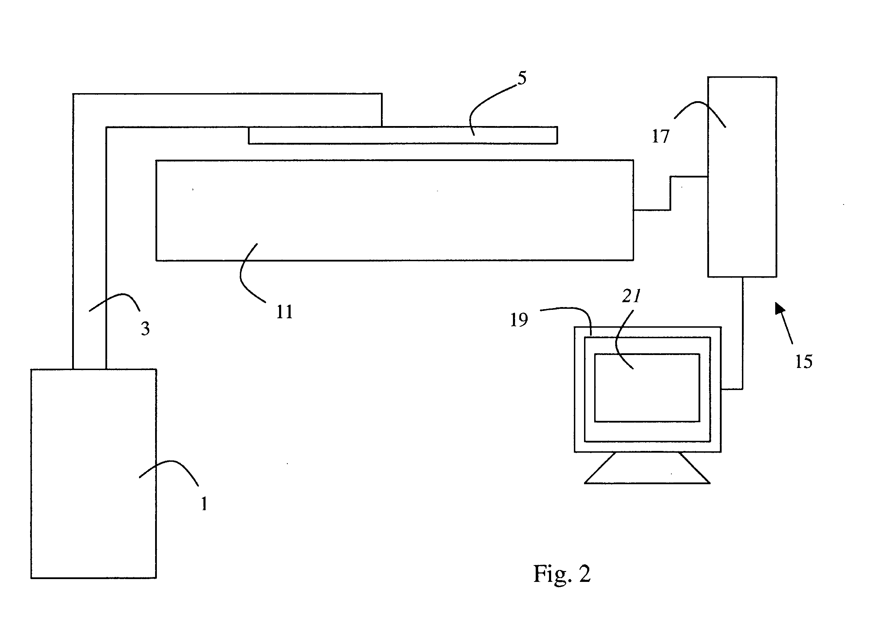

Fig. 2 zeigt ein weiteres Defektanalysesystem, bei dem der Flachbettscanner 11 in Normallage betrieben wird. Der Roboterarm 3 ist in diesem Ausführungsbeispiel so ausgeführt, dass der Wafer um 180 Grad um die Waagerechte drehbar ist. Die Bilddatenübermittlung und Bilddatenauswertung erfolgt analog zu dem in Fig. 1 gezeigten Defektanalysesystem.

Die Erfindung wurde in Bezug auf eine besondere Ausführungsform beschrieben. Es ist jedoch selbstverständlich, dass Änderungen und Abwandlungen durchgeführt werden können, ohne dabei den Schutzbereich der nachstehenden Ansprüche zu verlassen.

### Bezugszeichenliste:

- 1: Roboter
- 3: Roboterarm
- 5: Wafer
- 7: Waferchuck
- 9: Tisch
- 11: Flachbettscanner
- 13: Handlingsystem
- 15: Bildverarbeitungseinheit
- 17: PC
- 19: Display
- 21: Abbild

## Patentansprüche

1. Verfahren zur Defektanalyse von Wafern **gekennzeichnet durch** folgende Schritte:
• Erzeugen von Bilddaten **durch** optisches Abtasten des Wafers mit einem Flachbettscanner,
• Übermitteln der Bilddaten an eine Bildverarbeitungseinheit und
• Auswerten der erzeugten Bilddaten in der Bildverarbeitungseinheit.

2. Verfahren nach Anspruch 1, **dadurch gekennzeichnet, dass** das optische Abtasten des Wafers das Beleuchten des Wafers mit Beleuchtungslicht und das Detektieren von vom Wafer ausgehenden Detektionslicht umfasst.

3. Verfahren nach Anspruch 1, **gekennzeichnet durch** den weiteren Schritt:
• Auswählen der Wellenlänge des Beleuchtungslichts.

4. Verfahren nach Anspruch 1, **dadurch gekennzeichnet, dass** das optische Abtasten mehrmals sequentiell hintereinander jeweils mit Beleuchtungslicht unterschiedlicher Wellenlänge erfolgt.

5. Verfahren nach Anspruch 1, **dadurch gekennzeichnet, dass** die Bildverarbeitungseinheit einen PC umfasst.

6. Verfahren nach Anspruch 1, **dadurch gekennzeichnet, dass** der Flachbettscanner ein Zeilenscanner ist.

7. Defektanalysesystem für Wafer mit einer optischen Abtastvorrichtung und einer Bildverarbeitungseinheit, **dadurch gekennzeichnet, dass** die optische Abtastvorrichtung ein Flachbettscanner ist.

8. Defektanalysesystem nach Anspruch 7, **dadurch gekennzeichnet, dass** der Flachbettscanner mindestens eine Beleuchtungseinheit, die Beleuchtungslicht emittiert, umfasst.

9. Defektanalysesystem nach Anspruch 8, **dadurch gekennzeichnet, dass** die Wellenlänge des Beleuchtungslichtes auswählbar ist.

10. Defektanalysesystem nach Anspruch 7, **dadurch gekennzeichnet, dass** die Bildverarbeitungseinheit einen PC umfasst.

11. Defektanalysesystem nach Anspruch 7, **dadurch gekennzeichnet, dass** der Flachbettscanner ein Zeilenscanner ist.
